Europäisches Patentamt

European Patent Office

Office européen des brevets

(19)

(11) Veröffentlichungsnummer: **0 204 291 B1**

# (12) EUROPÄISCHE PATENTSCHRIFT

(45) Veröffentlichungstag der Patentschrift: **09.10.91**

(51) Int. Cl.⁵: **B07C 5/344**, G01R 31/28

(21) Anmeldenummer: **86107427.6**

(22) Anmeldetag: **02.06.86**

(54) **Einrichtung zum Prüfen und Sortieren von elektronischen Bauelementen, insbesondere integrierten Chips.**

(30) Priorität: 04.06.85 DE 3520031
30.08.85 DE 3531119
30.08.85 DE 3531120
30.08.85 DE 3531142
30.08.85 DE 3531143

(43) Veröffentlichungstag der Anmeldung:
**10.12.86 Patentblatt 86/50**

(45) Bekanntmachung des Hinweises auf die
Patenterteilung:
**09.10.91 Patentblatt 91/41**

(84) Benannte Vertragsstaaten:
**AT BE CH DE FR GB IT LI LU NL SE**

(56) Entgegenhaltungen:
**EP-A- 0 007 650     EP-A- 0 144 715
EP-A- 0 162 207     DE-A- 2 434 603
DE-A- 3 217 531     FR-A- 2 505 504
US-A- 4 478 352**

(73) Patentinhaber: **Willberg, Hans-Heinrich
Rottenbucherstrasse 39
W-8000 München 70(DE)**

Patentinhaber: **Ueberreiter, Ekkehard
Drosselweg 14
W-8201 Raubling(DE)**

(72) Erfinder: **Willberg, Hans-Heinrich
Rottenbucherstrasse 39
W-8000 München 70(DE)**     .
Erfinder: **Ueberreiter, Ekkehard
Drosselweg 14
W-8201 Raubling(DE)**

(74) Vertreter: **Schmidt-Evers, Jürgen, Dipl.-Ing. et
al
Patentanwälte Dipl.-Ing. H. Mitscherlich
Dipl.-Ing. K. Gunschmann Dipl.-Ing.
Dr.rer.nat. W. Körber Dipl.-Ing. J. Schmidt-
Evers Dipl.-Ing. W. Melzer Steinsdorfstrasse
10
W-8000 München 22(DE)**

**Beschreibung**

Nach der unter Artikel 54 (3) EPÜ fallenden EP-A1-162 207 ist eine Einrichtung zum Prüfen und Sortieren von elektronischen Bauelementen, insbesondere integrierten Chips, bekannt, bei der die zu prüfenden Bauelemente auf einer ein Gefälle aufweisenden Rampe zu einer Aufnahmestelle geführt werden. Oberhalb der Aufnahmestelle erstreckt sich ein um eine erste vertikale Achse schwenkbarer zweiteiliger Roboterarm. Der außen liegende Teil des zweiteiligen Roboterarms ist zusätzlich um eine zweite vertikale Achse gegenüber dem innen liegenden Teil schwenkbar. An dem äußeren Ende des außen liegenden Teils des Roboterarms befindet sich ein nach unten gerichteter Greifer, der um eine dritte vertikale Achse drehbar und außerdem vertikal verschiebbar ist. Mit diesem Greifer kann ein zu prüfendes Bauelement von der Aufnahmestelle aufgenommen werden. Nach der Aufnahme eines Bauelementes durch den Greifer wird dieser nach oben bewegt. Dabei werden an dem Greifer beweglich angeordnete Prüfkontakte gegen das in dem Greifer festgehaltene Bauelement gefahren. Entsprechend dem Prüfergebnis fährt der Roboterarm den Greifer dann über eine von zwei möglichen Ablagestellen, von denen die eine zur Ablage der guten Bauelemente und die andere zur Ablage der defekten Bauelemente dient. Die Prüfkontakte sind hier in doppelter Hinsicht beweglich, und zwar einmal mit dem Greifer und zum anderen am Greifer selbst. Die Beweglichkeit der Prüfkontakte bedingt flexible Zuleitungen zwischen den Prüfkontakten und der Testelektronik, die infolge ihrer unvermeidbaren Eigeninduktivitäten und Streukapazitäten eine relativ niedrige Grenze für die Testfrequenzen setzen.

Der Erfindung liegt die Aufgabe zugrunde, eine Einrichtung zum Prüfen und Sortieren von elektronischen Bauelementen, insbesondere integrierten Chips, zu schaffen, die sich durch eine einfache Betriebsweise und insbesondere dadurch auszeichnet, daß die einem Betrieb mit hohen Frequenzen entgegenstehenden Eigenimpedanzen und Streukapazitäten der Zuleitungen für die Prüfkontakte reduziert werden können.

Die Aufgabe ist gemäß Anspruch 1 mit einer Einrichtung gelöst, die folgende Merkmale aufweist:

a) ein ein Gefälle aufweisender Prüfkanal (69), in dem die Bauelemente (36) durch Schwerkraft transportiert werden,

b) seitlich am Prüfkanal (69) ortsfest in einem Prüfkontakthalter (91; 140) angeordnete und von diesem vorstehende Prüfkontakte (90; 148),

c) ein quer zur Transportrichtung der Bauelemente (36) verschiebbarer Prüfkäfig (78; 142), der einen Prüfraum (88) zur Aufnahme eines zu prüfenden Bauelementes (36) aufweist, wobei der Prüfraum (88) eine Teil des Prüfkanals (69) bildet,

d) Öffnungen (89; 145) in dem Prüfkäfig (78; 142), durch die bei Verschiebung des Prüfkäfigs (78; 142) die ortsfesten Prüfkontakte (90; 148) in den Prüfraum (88) eintretem können.

Hinzuweisen ist noch auf den in der DE-A-24 34 603 beschriebenen Stand der Technik. Danach ist es bekannt, zu kontrollierende Gegenstände mittels eines Förderbandes bis zu einer Kontrollstelle zu bewegen und hier quer zur Förderrichtung zwecks Abtastung mit Meßfühlern mittels einer Stützplatte anzuheben. Nach der Abtastung wird die Stützplatte wieder abgesenkt und der Gegenstand wieder auf das laufenden Förderband aufgesetzt. Die Stützplatte hat nicht die Form eines Käfigs und braucht diese auch nicht zu haben, da sich der Gegenstand beim Absenken der Stützplatte mit dieser infolge der Schwerkraft nach unten bewegt. Wenn - wie bei der erfindungsgemäßen Einrichtung - die Verschiebung des Bauelementes zum Zwecke der Prüfung nicht in vertikaler Richtung erfolgt, sondern u. U. wegen des ein Gefälle aufweisenden Prüfkanals in horizontaler Richtung, so muß Sorge dafür getragen werden, daß das geprüfte Bauelement nach der Prüfung wieder in seine Ausgangslage in den Prüfkanal zurückbewegt wird. Dies ist im Falle der Erfindung durch den Prüfkäfig gewährleistet.

Gemäß einer ersten Ausführungsform können die Prüfkontakte von Prüfstiften gebildet sein. Die Öffnungen in dem Prüfkäfig werden dann zweckmäßigerweise als Löcher ausgebildet.

Um eine sichere Verbindung zwischen den Prüfstiften und den Anschlußkontakten der Bauelemente zu gewährleisten, kann der dem Prüfkäfig zugewandte Endbereich der Prüfstifte gegenüber dem Hauptteil der Prüfstifte teleskopische verschiebbar sein, wobei zusätzlich an diesem Endbereich ein Stiftkopf vorgesehen wird, der vorzugsweise die Form einer gezackten Krone hat.

Gemäß einer zweiten Ausführungsform können die Prüfkontakte von flachen Kontaktzungen gebildet sein. Die Öffnungen in dem Prüfkäfig werden in diesem Fall zweckmäßigerweise als nach einer Seite hin offene Stützschlitze für die Kontaktzungen ausgebildet, in denen die Kontaktzungen an ihrer dem zu prüfenden Bauelement abgewandten Kante abgestützt werden. Die Abmessungen werden in diesem Falle so gewählt, daß die Anschlußkontakte des im Prüfkäfig befindlichen Bauelementes beim Verschieben des Prüfkäfigs mit der anderen Kante der Kontaktzungen in Reibkontakt treten. Durch den Reibkontakt werden Korrosionsschichten, die sich auf den Anschlußkontakten der Bauelemente bilden können, abgerieben, so daß auch hier eine einwandfreie Kontaktverbindung gewährleistet ist.

Es ist ferner zweckmäßig, die zuletzt erwähnten Kontaktzungen in dem Bereich, in dem sie Anschlußkontakte der zu prüfenden Bauelemente berühren sollen, einen verbreiterten Abschnitt zu geben, der am Ende spitz zuläuft.

Eine fertigungstechnisch günstige Konstruktion ergibt sich, wenn sowohl der Prüfkontakthalter als auch der Prüfkäfig an jeweils zwei gegenüberliegenden Seiten mit die Stützschlitze für die Kontaktzungen enthaltenden Vorsprüngen versehen werden.

Eine andere Weiterbildung der Erfindung, die beide Ausführungsformen betrifft, kann darin bestehen, daß an dem Prüfkontakthalter zwischen den Prüfkontakten ein Raum zur Unterbringung von Erdungskapazitäten vorgesehen ist.

Zur Verschiebung des Prüfkäfigs wird vorzugsweise ein Verschiebantrieb vorgesehen.

Eine Ausführungsbeispiel der Erfindung wird nachfolgend anhand der Zeichnungen beschrieben.

Es zeigen:

Fig. 1
eine Seitenansicht der Einrichtung;

Fig. 2
eine Längsschnitt durch das Eingangsmagazin;

Fig. 3
einen Querschnitt durch das Eingangsmagazin;

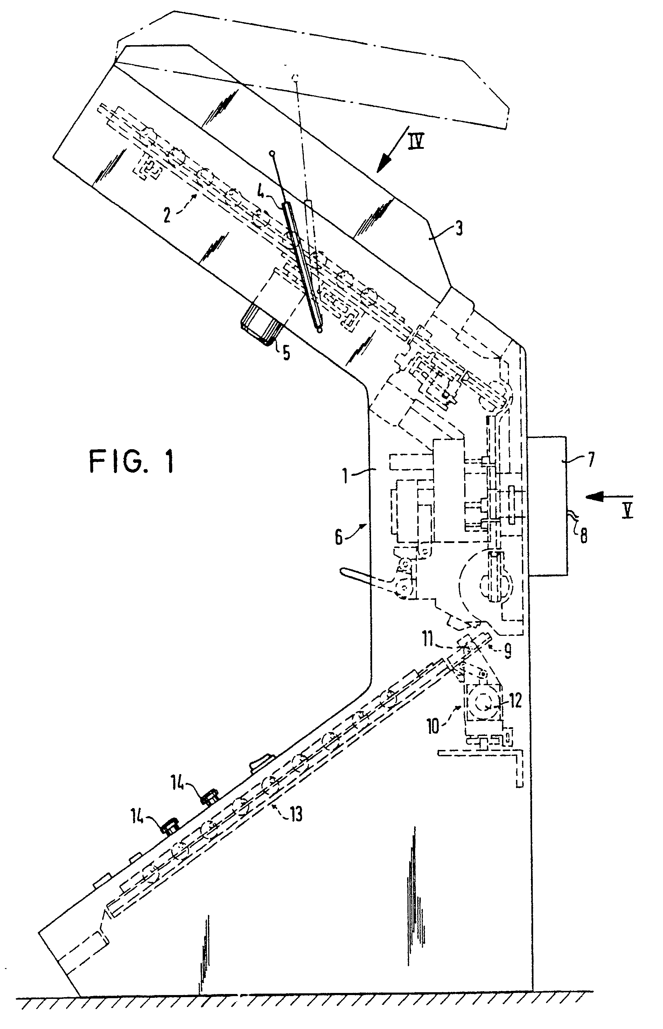

Fig. 4
eine Draufsicht IV in Fig. 1 auf das Eingangsmagazin (ohne Decke);

Fig. 5
eine Ansicht V von hinten gegen die Vorrichtung (ohne Stecker);

Fig. 6
einen Schnitt durch die Testeinheit und das Shuttle;

Fig. 7a und 7b
Schnitte durch die Vereinzelungsvorrichtung und die Kippvorrichtung in verschiedenen Stellungen;

Fig. 8a bis 8c
Schnitte durch die Wendevorrichtung und das Shuttle in verschiedenen Stellungen;

Fig. 9a
einen Schnitt durch den Prüfstifthalter und den Prüfkäfig für CLCC's;

Fig. 9b
eine perspektivische Darstellung des Prüfkäfigs für CLCC's;

Fig. 10a
einen Schnitt durch den Prüfstifthalter und den Prüfkäfig für PLCC's;

Fig. 10b
eine perspektivische Explosionsdarstellung vom Prüfstifthalter und Prüfkäfig für PLCC's;

Fig. 11
eine perspektivische Darstellung eines CLCC's;

Fig. 12
eine perspektivische Darstellung eines PLCC's.

Die in den Figuren Seitenansicht gezeigte Einrichtung ist in einem Gehäuse 1 untergebracht. Im oberen Teil des Gehäuses ist ein Eingangsmagazin 2 für die Bauelemente schräg angeordnet, so daß die darin befindlichen Bauelemente durch die Schwerkraft schräg nach unten rutschen. Über dem Eingangsmagazin 2 ist ein Deckel 3 angeordnet, der - um das Eingangsmagazin 2 zugänglich zu machen - hochklappbar und mittels federnder Teleskopstangen 4 in dieser hochgeklappten Stellung abstützbar ist.

Das Eingangsmagazin 2 weist eine Vielzahl von (hier nicht sichtbaren) Magazinkanälen auf, in denen die Bauelemente angeordnet sind. Ferner ist das Eingangsmagazin mittels eines Antriebsmotors 5 senkrecht zur Zeichenebene verfahrbar, um einen gewünschten Magazinkanal in Flucht mit der Eingangsöffnung an einer Prüfeinheit 6 zu bringen.

In der stationär angeordneten Prüfeinheit 6 werden die Bauelemente nacheinander einzeln getestet. Die Prüfeinheit 6 ist dazu über einen Stecker 7 und ein Kabel mit einem (nicht dargestellten) Auswerte-Computer verbunden. Aufgrund der dem Auswerte-Computer zugeführten elektrischen Signale stellt dieser fest, ob die Bauelemente "gut" oder "schlecht" sind. Bei dem "guten" Bauelementen unterscheidet er noch zwischen verschiedenen Güteklassen. Das Auswerteergebnis wird der Einrichtung wiederum über das Kabel 8 zugeführt.

Unterhalb der Testeinheit ist ein Shuttle 9 angeordnet, welches mit einem Aufnahmekanal für ein Bauelement versehen ist. Das Shuttle 9 ist an einem Shuttle-Schlitten 10 angeordnet und um eine senkrecht zur Zeichenebene verlaufende Achse 11 schwenkbar. Der Shuttle-Schlitten 10 ist ferner auf einer Führungsstange 12 längs verschiebbar angeordnet. Die Führungsstange 12 verläuft ebenfalls senkrecht zur Zeichenebene.

Unterhalb des Shuttles 9 ist stationär ein schräg verlaufendes Ausgangsmagazin 13 angeordnet. Dieses weist ebenfalls eine Vielzahl von schräg verlaufenden Magazinkanälen zur Aufnahme der geprüften Bauelemente auf. Jeder Magazinkanal ist einer Güteklasse für die Bauelemente zugeordnet. Aufgrund der der Einrichtung von dem Auswerte-Computer zugeführten Auswertesignale verfährt der Shuttle-Schlitten 10 mit dem Shuttle 9 nach Aufnahme eines Bauelementes aus der Prüfeinheit 6 in eine Position, in der er mit dem der festgestellten Güteklasse entsprechenden Magazinkanal des Ausgangsmagazins 13 fluchtet und übergibt das Bauteil an diesen Magazinkanal

Mit der Bezugsziffer 14 sind Bedienungsknöpfe der Einrichtung bezeichnet.

Aus dem Ausgangsmagazin 13 können dann die sortierten Bauelemente durch Abfüllen in Magazinstangen entnommen werden.

Es ist ebenso möglich, daß die noch nicht geprüften Bauelemente in die Magazinkanäle des Eingangsmagazins 2 dadurch eingeführt werden, daß ein Stangenmagazin schräg an den entsprechenden Magazinkanal angesetzt wird, derart, daß das Stangenmagazin und der Magazinkanal miteinander fluchten.

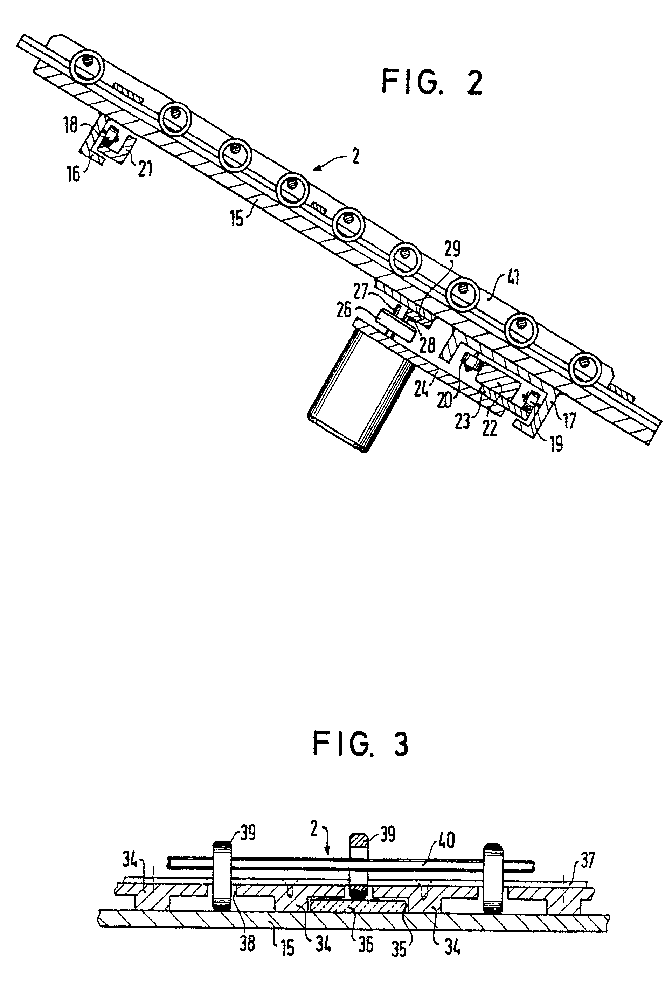

Die Fig. 2, 3 und 4 zeigen den Aufbau des Eingangsmagazins 2. Wie bereits erwähnt, ist das Eingangsmagazin verfahrbar, derart, daß es in einer bestimmten Position zu der stationären Prüfeinheit 6 gebracht werden kann. Das Ausgangsmagazin 13 ist im Prinzip ebenso wie das Eingangsmagazin 2 aufgebaut, mit dem Unterschied, daß es jedoch stationär ist. Es genügt deshalb, wenn das Eingangsmagazin 2 detailliert beschrieben wird.

Das Eingangsmagazin 2 besteht aus einer schräg angeordneten ebenen Grundplatte 15. An der Unterseite der Grundplatte 15 sind winkelförmige Trägerelemente 16, 17 befestigt, die Laufrollen 18, 19 und 20 tragen. Die Laufrollen 18 laufen auf einer sich senkrecht zur Zeichenebene erstreckenden Laufschiene 21. Die Laufrollen 19 und 20 laufen auf sich ebenfalls senkrecht zur Zeichenebene erstreckenden miteinander verbundenen Laufschienen 22 und 23. An der Laufschiene 23 sitzt eine Halteplatte 24, an welcher der Antriebsmotor 5 für das Eingangsmagazin 2 befestigt ist. Die Antriebswelle 25 des Antriebsmotors 5 trägt einen Exzenterkopf 26, an dem diagonal gegenüberliegend zwei Exzenterstifte 27, 28 befestigt sind. Diese greifen (nicht dargestellte) Rastausnehmungen einer Transportschiene 29 ein, welche an der Unterseite der Grundplatte 15 befestigt ist und sich senkrecht zur Zeichenebene erstreckt. Dieser Antrieb ist bekannt und bereits in der DE-OS 33 40 182 beschrieben.

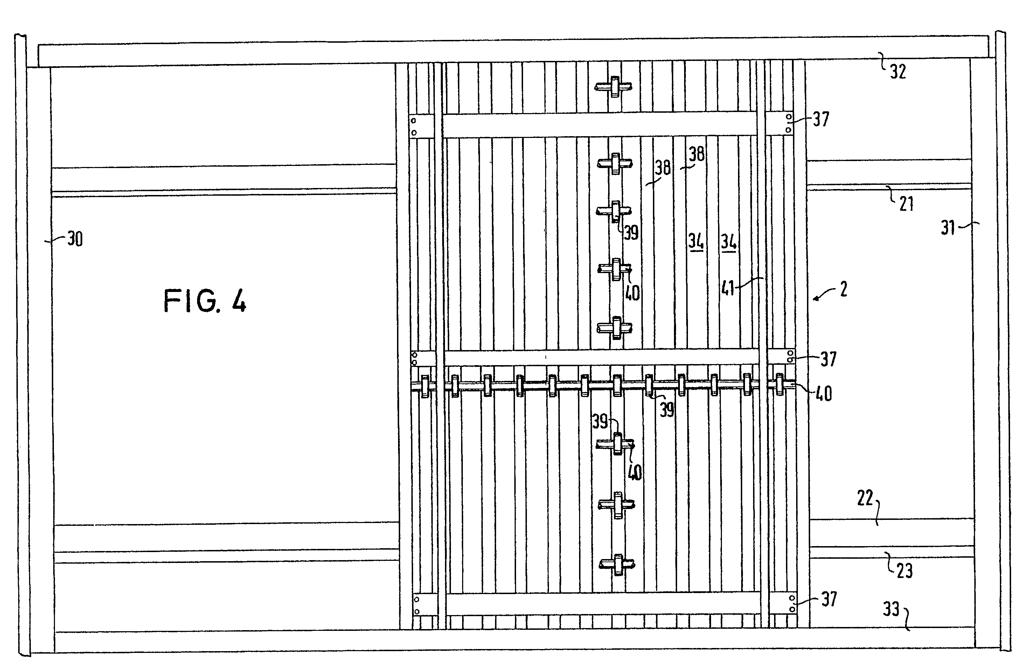

Wie man der Fig. 4 entnehmen kann, erstrecken sich die Laufschienen 21 und 22, 23 zwischen zwei Trägerstangen 30, 31, die mit weiteren Rahmenelementen 32, 33 einen Trägerrahmen für das verfahrbare Eingangsmagazin 2 bilden.

Wie insbesondere der Fig. 3 entnommen werden kann, sitzen auf der Grundplatte 15 im Schnitt T-förmige Führungsschienen 34, die die Magazinkanäle 35 für die Bauelemente 36 bilden. Die Führungsschienen 34 sind mittels sich quer über das Eingangsmagazin 2 erstreckenden Verbindungsleisten 37 miteinander verbunden. Zwischen den einzelnen Führungsschienen 34 verlaufen Spalten 38. Auf diese Weise bilden die über die Verbindungsleisten 37 zusammenhängenden Führungsschienen 34 ein gitterartiges Gebilde. Dieses kann dann, wenn Bauelemente 36 anderer Größe getestet werden sollen, gegen ein anderes gitterartiges Gebilde ausgetauscht werden, welches aus entsprechend angepaßten Führungsschienen 34 besteht. Die Führungsschienen 34 sind lediglich auf die Grundplatte 15 aufgelegt, und das ganze gitterartige Gebilde ist kann ohne weiteres von der Grundplatte 15 abgehoben.

In die Spalte 38 zwischen den Führungsschienen 34 ragen in Abständen Bremsrollen 39, die auf Trägerstangen 40 angeordnet sind. Der Innendurchmesser der Bremsrolle 39 ist sehr viel größer als der der Trägerstangen 40. In Fig. 4 sind die Bremsrollen 39 der übersichtlichkeithalber nur in einem Spalt 38 gezeigt. Es sind jedoch in jedem der Spalte 38 entsprechende Bremsrollen angeordnet.

Wenn sich in den Magazinkanälen 35 keine Bauelemente 36 befinden, so liegen die Bremsrollen auf der Grundplatte 15 auf. Wenn ein Bauelement 36 den Magazinkanal 35 infolge der Schwerkraft herabrutscht, so hebt er nacheinander die Bremsrollen 39 an und leitet unter diesen durch. Durch die Bremsrollen wird die Gleitgeschwindigkeit der Bauelemente 36 auf ein bestimmtes Maß reduziert. Dies ist notwendig, damit die Bauelemente 36 nicht beschädigt werden, wenn sie am Ende des schrägen Magazinkanals 35 gegen einen Anschlag treffen. Die Trägerstangen 40 für die Bremsrollen 39 sitzen in Halteschienen 41, 42, welche Teil des gitterartigen Gebildes sind.

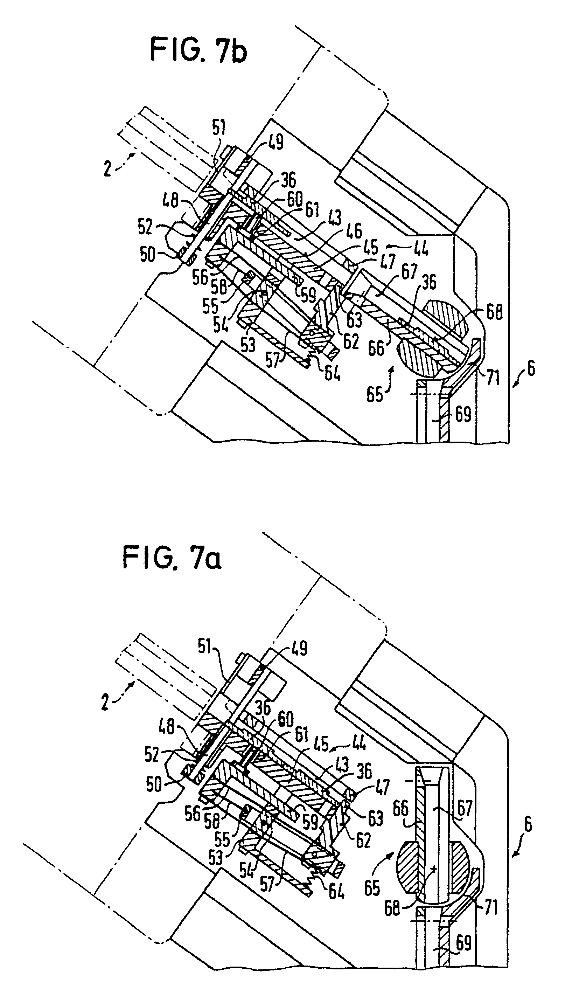

Wenn aus einem bestimmten Magazinkanal des Eingangsmagazins 2 Bauelemente entnommen werden sollen, so wird das Eingangsmagazin in die Position gefahren, in der der Magazinkanal mit einem Vereinzelungskanal 43 einer Vereinzelungsvorrichtung 44 fluchtet. Die Vereinzelungsvorrichtung 44 soll nachfolgend anhand der Fig. 7a und 7b beschrieben werden.

Die Vereinzelungsvorrichtung besteht aus einem Basisteil 45, welches eine Laufebene 46 für die Bauteile bildet. Über der Laufebene ist mit Abstand eine Deckplatte 47 angeordnet, die mit dem Basisteil den Vereinzelungskanal 43 bildet. Im Basisteil 45 sind verschiebbar zwei Führungsstangen 48 gelagert, welche an ihrem oberen Ende durch einen Trägerblock 49 und an ihrem unteren Ende durch einen Trägerblock 50 miteinander verbunden sind. Der obere Trägerblock 49 trägt einen sich nach unten erstreckenden Schieber 51, welcher in Fig. 7b den Vereinzelungskanal 43 verschließt und in Fig. 7a freigibt. Zwischen dem Basisteil 45 und dem unteren Trägerblock 50 sind die Führungsstangen 48 umgebende Federn 52 angeordnet, die den Schieber 51 in der in Fig. 7b gezeigten Schließstellung zu halten suchen. Die Betätigung des Schiebers 51 erfolgt durch einen hier nicht dargestellten Antrieb, welcher vorzugsweise an dem unteren Trägerblock 50 angreift. Dieser Antrieb kann beispielsweise ein Elektromagnet oder ein pneumatisch betriebener Zylinder sein.

An der Unterseite des Basisteiles 45 ist ein Pendelträger 53 befestigt. An diesem ist um einen Gelenkpunkt 54 ein Pendelrahmen 55 schwenkbar angeordnet. Außerdem sind in dem Pendelträger 53 zwei Blattfedern 56, 57 eingeklemmt. Eine weitere Blattfeder 58 geht von dem Pendelrahmen 55 aus. Die drei Blattfedern 56, 57, 58 sind ferner an ihrem einen Ende mit einem Klemmstösselträger 59 verbunden, welcher mit einem Klemmstössel 60 versehen ist. Dieser erstreckt sich durch eine Öffnung 61 in dem Basisteil 45. Das andere Ende der beiden Blattfedern 56, 57 sowie der Pendelrahmen 55 sind mit einem Schließteil 62 verbunden, welches an seinem oberen Ende eine Schließnase 63 aufweist. In Fig. 7a verschließt die Schließnase den Vereinzelungskanal 43, während sie ihn in Fig. 7b freigibt. Zwischen dem Schließteil 62 und dem Pendelträger 53 befindet sich eine Feder 64, welche das Schließteil 62 nach oben zu drücken sucht, derart, daß die Schließnase 63 den Vereinzelungskanal 43 verschließt (Fig. 7a).

An die Vereinzelungsvorrichtung 43 schließt sich eine Kippvorrichtung 65 an, die aus einem Kippteil 66 besteht, welches einen Kippkanal 67 enthält und um eine Drehachse 68 drehbar. Unterhalb der Kippvorrichtung 65 liegt ein senkrecht verlaufender Prüfkanal 69.

Die Kippvorrichtung 65 arbeitet mit der Vereinzelungsvorrichtung 44 zusammen. Das Zusammenwirken ist in den Fig. 7a und 7b dargestellt. Es besteht im wesentlichen darin, daß das Kippteil 66 in der in der Fig. 7b gezeigten Aufnahmeposition auf eine Schulter 70 des Schließteiles 62 drückt und dieses entgegen der Wirkung der Feder 64 in einer unteren Position hält, in der die Schließnase 63 den Weg zwischen dem Vereinzelungskanal 43 und dem Kippkanal 67 freigibt. Gleichzeitig wird der Pendelrahmen 55 um den Drehpunkt 54 geschwenkt, mit der Folge, daß diese Bewegung über die Blattfedern 56, 57, 58 auf den Klemmstösselträger 59 übertragen, welcher dadurch in eine obere Position gezwungen wird, in der der Klemmstössel 60 durch das Loch 61 in dem Basisteil 46 hindurch in den Vereinzelungskanal 43 eintaucht und ein über ihm befindliches Bauelement gegen die Deckplatte 47 preßt und dadurch am Weiterrutschen nicht hindert.

Die Funktion der Vereinzelungsvorrichtung ist nun wie folgt:
Zunächst wird der Schieber 51 geöffnet, so daß, wie in Fig. 7a dargestellt, zwei Bauelemente in den Vereinzelungskanal 43 hineinrutschen können und dort gegen die Schließnase 63 treffen. Die Länge des Vereinzelungskanales 43 ist gerade so bemessen, daß sie der Länge von zwei Bauelementen 36 entspricht. Dann wird, wie in Fig. 7b gezeigt, der Schieber 51 wieder geschlossen und die Kippvorrichtung 65 geschwenkt, derart, daß das Kippteil 66 das Schließteil 62 nach unten drückt. Dadurch gibt die Schließnase 63 den Weg zwischen dem Vereinzelungskanal 43 und dem Kippkanal 67 frei. Gleichzeitig wird der Klemmstössel 60 nach oben gedrückt und preßt das in Transportrichtung vorletzte Bauelement 36 gegen die Deckplatte 47. Das in Transportrichtung letzte Bauelement 36 kann nun in den Kippkanal 67 rutschen. Es kann diesen aber nicht verlassen, weil der Kippkanal an seinem unteren Ende durch ein bogenförmiges Sperrteil 71 verschlossen ist. Danach wird die Kippvorrichtung 65 wieder in die in Fig. 7a gezeigte Stellung geschwenkt mit der Folge, daß der Kippkanal 67 mit dem Prüfkanal 69 fluchtet und daß im Kippkanal 67 befindliche Bauelement in den Testkanal 69 rutschen kann. Gleichzeitig verschließt die Schließnase 63 wieder den Vereinzelungskanal 43, und der Klemmstössel 60 wird aus dem Vereinzelungskanal 43 zurückgezogen. Dadurch kann das in Transportrichtung bisher vorletzte Bauelement weiterrutschen, bis es gegen die Schließnase 63 trifft. Bei erneutem Öffnen des Schiebers 51 kann nun ein weiteres Bauelement aus dem Magazinkanal in den Vereinzelungskanal 43 rutschen. Wenn ein Magazinkanal des Eingangsmagazins leer ist, schließt der Schieber 51. Nun wird das Eingangsmagazin 2 seitlich verfahren bis der nächste Magazinkanal vor dem Vereinzelungskanal zu liegen kommt. Nun öffnet der Schieber 51 wieder bis auch die Bandelemente dieses Magazinkanals abgearbeitet sind. Dieser Vorgang spielt sich in wiederholter Folge ab.

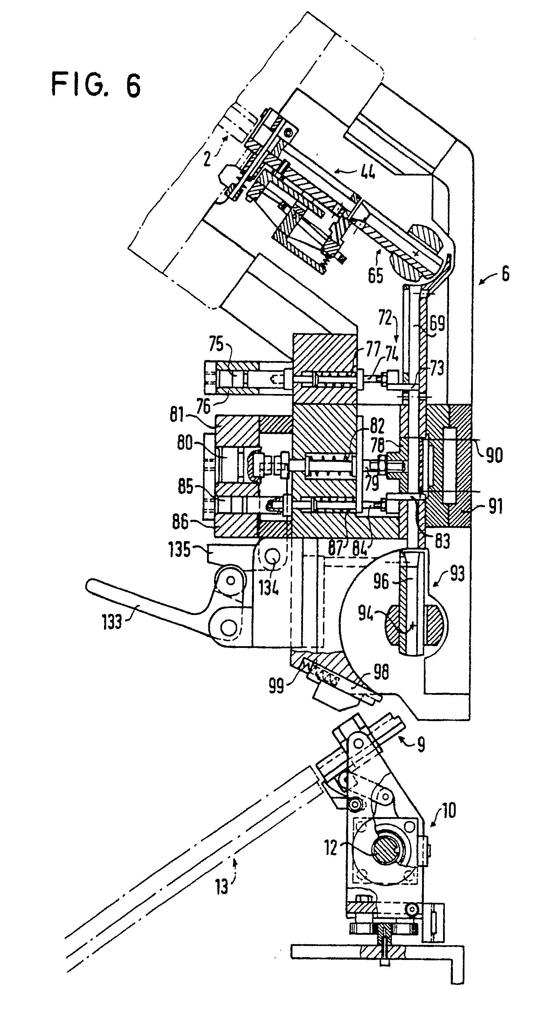

Die weitere Verarbeitung der Bauelemente soll anhand von Fig. 6 beschrieben werden. Wenn die Kippvorrichtung 65 aus der dargestellten geneigten Position (wie in Fig. 7b) in die vertikale Position (wie in Fig. 7a) geschwenkt wird, fällt das darin enthaltene Bauteil in den Prüfkanal 69 der Prüfvorrichtung 72. Es trifft zunächst auf einen Anschlag 73, der in vorgeschobener Position dargestellt ist. Der Anschlag 73 ist über einen Stössel 74 mit dem Kolben 75 eines Pneumatikzylinders 76 verbunden. Eine Feder 77 versucht den Anschlag 73 in Öffnungsstellung zu halten. Wenn Luft auf den Pneumatikzylinder gegeben wird, wird der Anschlag 73 entgegen der Wirkung der Feder 77 in die in Fig. 6 gezeigte Position geschoben.

Wenn der Anschlag 73 zurückgezogen wird, so fällt das Bauteil weiter durch den Prüfkanal 69 in einen Prüfkäfig 78. Der Prüfkäfig ist über einen Stössel 79 mit dem Kolben 80 eines weiteren Pneumatikzylinders 81 verbunden. Eine Feder 82 versucht den Prüfkäfig 78 in der zurückgezogenen dargestellten Stellung zu halten. Wenn Druck auf den Zylinder 81 gegeben wird, so wird der Prüfkäfig 78 mit den darin befindlichen Bauteil um ein kleines Stück nach rechts verschoben.

Unterhalb des Prüfkäfigs befindet sich ein weiterer Anschlag 83, der über einen Stössel 84 mit dem Kolben 85 eines Pneumatikzylinders 86 verbunden ist. Eine Feder 87 versucht den Anschlag 83 in eine zurückgezogene Stellung zu drängen. Wenn Luft auf den Pneumatikzylinder 86 gegeben wird, so wird der Anschlag 83 entgegen der Wirkung der Feder 87 in die in Fig. 6 gezeigte Position vorgerückt. In der vorgeschobenen Position hält der Anschlag 83 das Bauteil in dem Prüfkäfig.

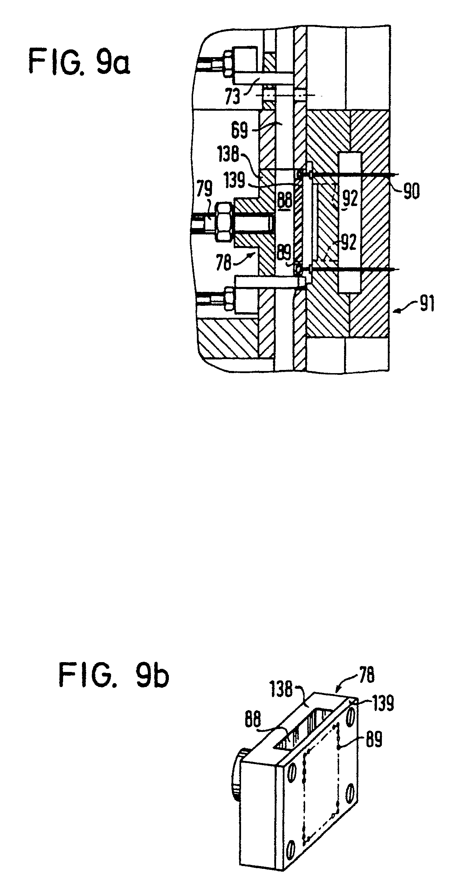

Der Prüfkäfig 78 ist in Fig. 9a im Schnitt vergrößert und in Fig. 9b perspektivisch dargestellt. Er besteht aus einem gefrästen Metallteil 138 mit einer aufgesetzten Kunststoff-Platte 139. Beide schließen einen einen Teil des Prüfkanales 69 bildenden Prüfraum 88 ein. Die Kunststoff-Platte 139 ist mit im Viereck angeordneten Löchern 89 versehen. In die Löcher 89 ragen die Endabschnitte von Prüfstiften 90. Beide Endabschnitte der Prüfstifte 90 sind gegenüber dem Mittelteil teleskopisch verschiebbar. Die in die Löcher 89 ragenden Endabschnitte der Prüfstifte 90 sind am Ende mit gezackten Kontaktkronen versehen. Die Prüfstifte sind in einem zweiteiligen Prüfstifthalter 91 angeordnet, der aus Isoliermaterial besteht. Die rechts aus dem Prüfstifthalter 91 herausragenden teleskopisch verschiebbaren Endabschnitte der Prüfstifte 90 werden mit dem in Fig. 1 gezeigten Stecker 7 in Kontakt gebracht. Es ist auch möglich, den durch die gestrichelten Linien 92 angedeuteten Teil aus dem Prüfstifthalter 91 herauszunehmen, um so Platz zu schaffen, für Erdungskapazitäten, die ganz nah an die Endabschnitte der Prüfstifte herangeführt werden können. Mit diesen Erdungskapazitäten können die Verhältnisse simuliert werden, die nach einem Einlöten der Bauelemente auf der Leiterplatte herrschen.

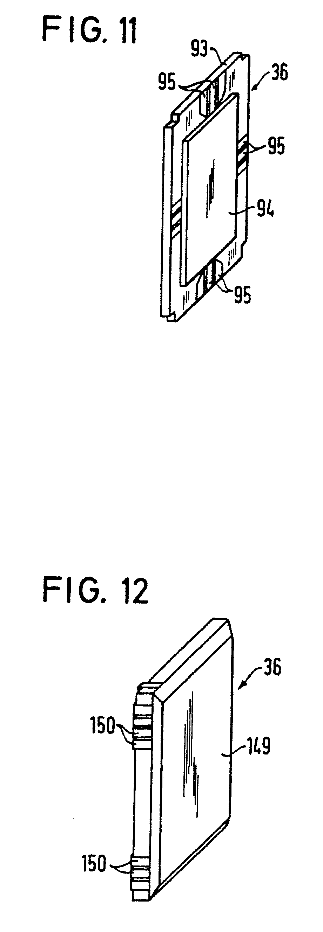

Für den zur vorbeschriebenen Prüfkäfig 78 sowie die entsprechenden Prüfstifte 90 kommen Bauelemente in Frage, von denen eines in Fig. 11 dargestellt ist. Es handelt sich hierbei um ein sog. CLCC (ceramec leadless chip carrier). Dieses CLCC besteht aus einem Keramikgrundkörper 93, der in der Mitte mit einer Erhöhung 94 versehen ist. Von dieser Erhöhung 94 gehen nach allen vier Seiten vergoldete Kontaktbahnen 95 aus, die sich bis zum Rand des Keramikgrundkörpers 93 erstrecken. In Fig. 11 sind der Einfachheit halber nur einige Kontaktbahnen 95 angedeutet. Die Kontaktkronen der sich durch die Löcher 89 des Prüfkäfigs erstreckenden Endabschnitte der Prüfstifte 90 setzen auf diese vergoldeten Kontaktbahnen 95 auf, wenn der Prüfkäfig 88 gegenüber der in Fig. 9a gezeigten Stellung nach rechts verschoben wird.

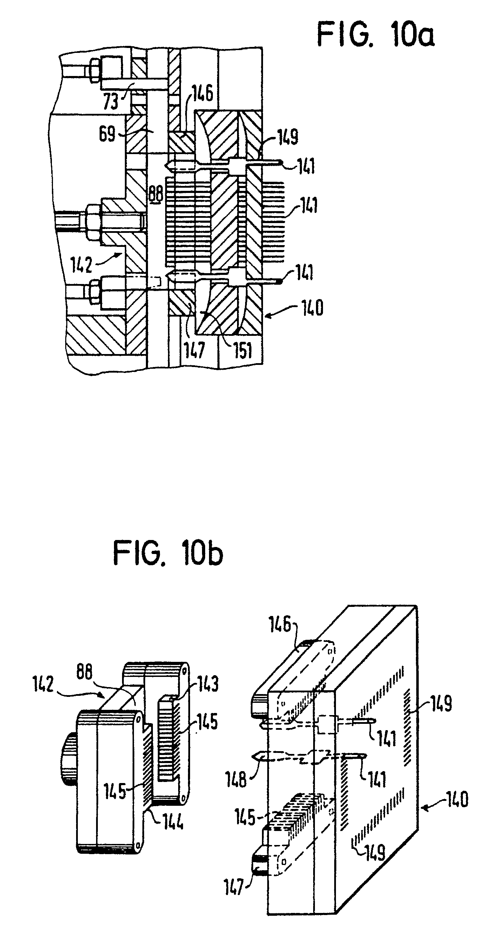

Anstelle der in Fig. 11 gezeigten CLCC's können auch PLCC's verwendet werden, wie sie in Fig. 12 gezeigt sind. Diese bestehen aus einem Plastikgehäuse 149, von dessen Rand an allen vier Seiten Anschlußkontakte 150 ausgehen, die an der Unterseite nach innen umgebogen sind. Die Anschlußkontakte sind verzinnt. Da Zinn korrodiert, kann ein sicherer Kontakt nur gewährleistet werden, wenn die Prüfstifte in Reibkontakt mit den Anschlußkontakten 150 gebracht werden. In den Fig. 10a und 10b sind ein Prüfkäfig 142 sowie ein entsprechender Prüfstifthalter 140 gezeigt, die diese Bedingung erfüllen. Der zweiteilige Prüfstifthalter 140 besteht aus Kunststoffmaterial. Er ist mit Schlitzen 149 versehen, in die Prüfstifte 141 eingesteckt sind. Die Prüfstifte sind aus Kontaktblech ausgestanzt. Sie weisen an ihrem linken Ende einen verbreiterten Kontaktbereich 148 auf. Mit den seitlichen Stirnkanten dieser verbreiterten Kontaktbereiche 148 sollen die Prüfstifte in Reibkontakt mit den Anschlußkontakten der PLLC's treten. Dazu müssen sie seitlich abgestützt werden. Der Prüfstifthalter 140 weist dazu an seiner linken Seite oben und unten Vorsprünge 146, 147 auf, die mit Schlitzen 145 versehen sind, in welche die verbreiterten Kontaktbereich 148 der in der oberen und unteren Reihe angeordneten Prüfstifte 141 über den größten Teil ihrer Breite eintauchen. Der ebenfalls aus Isoliermaterial, vorzugsweise aus Kunststoff hergestellte Prüfkäfig 142 ist - von oben gesehen - C-förmig ausgebidet und umschließt einen Prüfraum 88. An den beiden vertikalen Seiten ist der Käfig 142 mit nach innen vorspringenden Leisten 143, 144 versehen, die ebenfalls Schlitze 145 aufweisen. In diese Schlitze tauchen die verbreiterten Kontaktbereiche 148 derjenigen Prüfstifte 141 ein, die in den beiden vertikalen Prüfstift-Reihen angeordnet sind. Auch hier tauchen die verbreiterten Kontaktbereich 148 nicht über die ganze Breite in die Schlitze 145, sondern nur über den größten Teil ihrer Breite. Wenn der Prüfkäfig 142 in Fig. 10a nach rechts verschoben wird, so kommen die verbreiterten und vornangeschrägten Kontaktbereiche 148 der Prüfstifte 141 mit den Kontaktbahnen 150 der PLCC's (Fig. 12) in Reibkontakt. Der Prüfstifthalter 140 ist auch hier nur einem freien Raum 151 versehen, in dem - falls gewünscht - Erdungskapazitäten untergebracht werden können.

Der weitere Gang der Bauelemente soll nunmehr wiederum anhand von Fig. 6 beschrieben werden. An dem unteren Teil des Prüfkanales 69, d.h. an denjenigen, der auf den Prüfkäfig 78 folgt, schließt sich eine Wendevorrichtung 93 an. Diese besteht aus einem um eine 94 drehbaren Wendeteil 95, welches einen Wendekanal 96 enthält. Der Wendekanal 96 ist am Ende geschlossen.

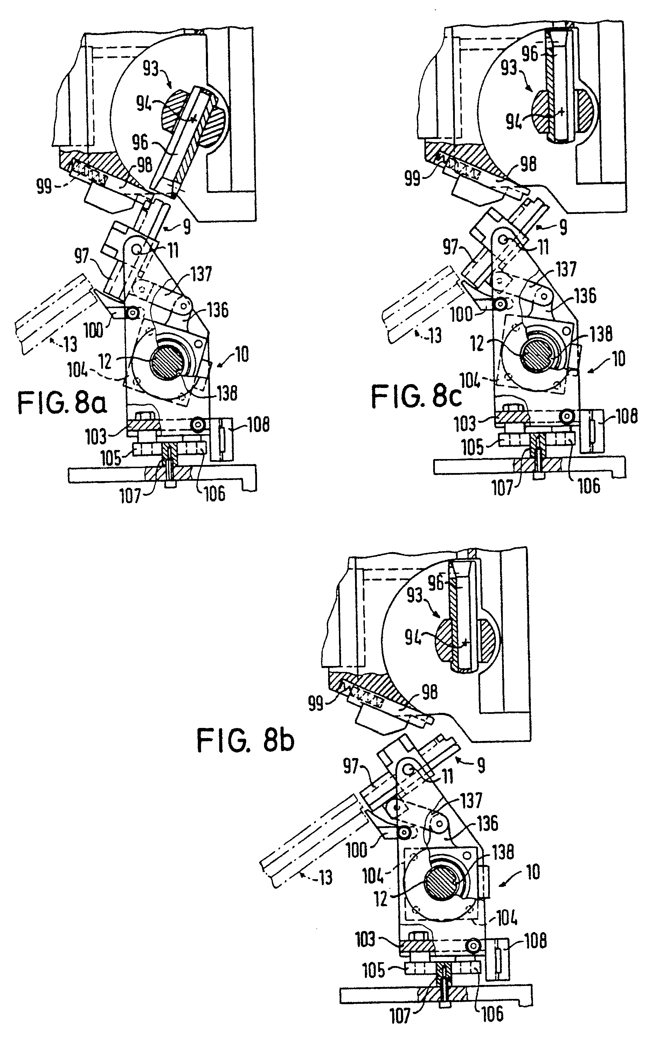

Wenn der Prüfkäfig 78 nach dem Prüfer eines in ihm befindlichen Bauelementes in die in Fig. 6 gezeigte Stellung zurückgezogen und der Anschlag 83 nach links verschoben wird, so fällt das im Prüfraum 88 befindliche Bauelement in den Wendekanal 96. Die Überführung dieses Bauteiles in das Shuttle 9 und von diesem in das Ausgangsmagazin 13 soll nunmehr anhand der Fig. 8a bis 8c beschrieben werden.

Das Shuttle 9 kann drei Stellungen einnehmen. Fig. 8a zeigt das Shuttle 9 in Beladestellung. Das Shuttle 9 ist mit einem Shuttle-Kanal 97 zur Aufnahme eines Bauelementes versehen. Ein das offene Ende des Wendekanals 96 normalerweise verschließendes Verschlußteil 98 wird entgegen der Wirkung einer Feder 99 durch das Shuttle zurückgedrückt, so daß der Wendekanal 96 geöffnet wird und das daran befindliche Bauteil in den mit dem Wendekanal 96 fluchtenden Shuttle-Kanal 97 gleiten kann. Das Herausfallen des Bauteiles aus dem Shuttle-Kanal 97 verhindert eine an dem Shuttle-Schlitten 10 befindliche Schaufel, deren Oberseite eine um die Schwenkachse 11 des Shuttles 9 verlaufende Zylinderkrümmung aufweist.

Fig. 8b zeigt das Shuttle 9 in Endladestellung. Hier fluchtet der Shuttle-Kanal 97 mit einem Magazinkanal des Ausgangsmagazins. Das obere Ende der Schaufel 100 erstreckt sich gerade bis zur Unterkante des Shuttle-Kanals 97. Ein im Shuttle-Kanal 97 befindliches Bauteil kann demnach in den ensprechenden Magazinkanal des Ausgangsmagazins 13 gleiten. Die Wendevorrichtung 93 ist wieder nach oben geschwenkt (wie Fig. 6).

Fig. 8c zeigt das Shuttle 9 in Transportstellung. Diese Transportstellung ist eine Zwischenstellung zwischen der Beladestellung und der Entladestellung. Einerseits verschließt die Schaufel 100 das untere Ende des Shuttle-Kanales 97; andererseits drückt das Shuttle 9 nicht mehr gegen das Verschlußteil 98 (wie in Fig. 8a). Das Verschlußteil 98 ist daher in vorgeschobener Stellung und würde den Wendekanal 96 verschließen, wenn die Wendevorrichtung 93 nach unten geschwenkt werden würde (wie in Fig. 8a).

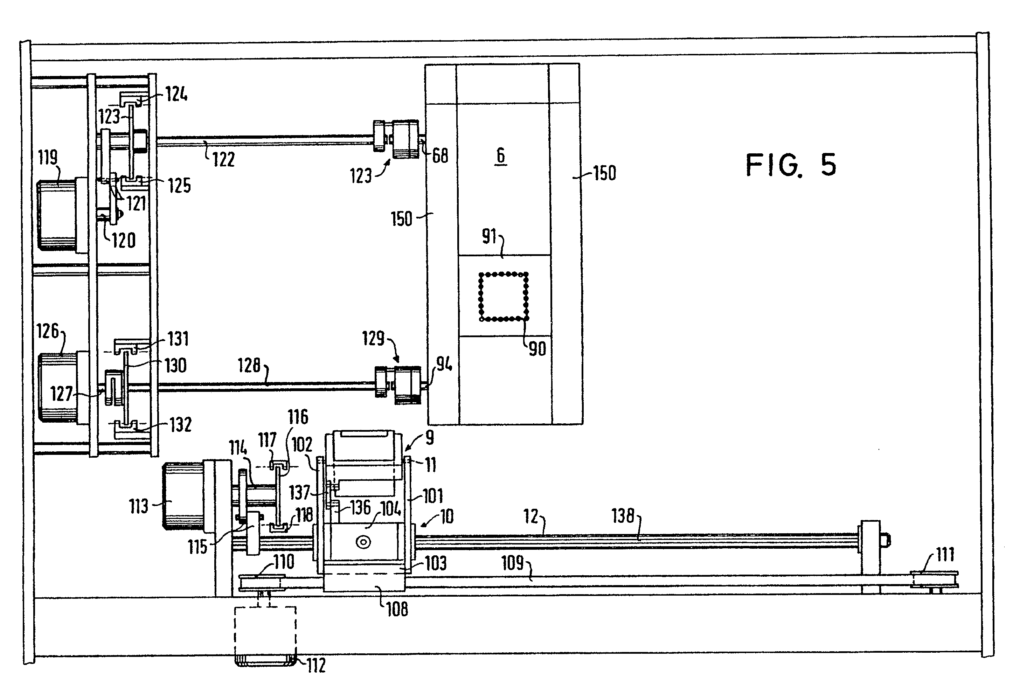

Der weitere Aufbau des Shuttles 9 und des Shuttle-Schlittens 10 sowie der Quertransport des Shuttles soll nunmehr anhand von Fig. 5 erläutert werden. Der Shuttle-Schlitten 10 weist zwei Seitenwangen 101, 102 auf, die durch ein Basisteil 103 miteinander verbunden sind. Zwischen den beiden Seitenwangen 101, 102 erstreckt sich die Schwenkachse 11 des Shuttles 9. Ferner erstreckt sich zwischen den beiden Seitenwangen 101, 102 drehbar eine Kugelbüchse 104. Diese ist drehfest mit der Führungsstange 12 verbunden, jedoch auf dieser verschiebbar. Die Führungsstange 12 weist dazu eine Nute 138 auf, in der eine Kugelreihe der Kugelbüchse 104 zur Erzielung der Längsverschiebbarkeit und Drehmitnahme läuft. Die Kugelbüchse 104 ist mit einem Ansatz 136, der über einen Hebel 137 gelenkig mit dem Shuttle 9 verbunden ist und eine Drehung der Kugelbüchse 104 auf das Shuttle 9 überträgt.

Wie man aus den Fig. 6 sowie 8a bis 8c entnehmen kann, sitzen an der Unterseite des Basisteiles 103 zwei Rollen 105, 106, die an den gegenüberliegenden Seiten einer gerätefesten Führungsschiene 107 anliegen. Diese ist der übersichtlichkeithalber in Fig. 5 nicht gezeigt. Ebenfalls mit dem Basisteil 103 verbunden ist ein Klemmteil 108, mittels welchem der Shuttle-Schlitten 10 mit einem Zahnriemen 109 verbunden ist. Der Zahnriemen 109 läuft über zwei gerätefeste Zahnrollen 110, 111. Die Rolle 110 ist mit einem Antriebsmotor 112 verbunden. Wenn der Antriebsmotor 112 in Betrieb gesetzt wird, so wird der Shuttle-Schlitten über den Zahnriemen 109 auf der Führungsstange 12 verschoben.

Der Antrieb zum Schwenken des Shuttles 9 wird von einem Schrittschaltmotor 113 (s. Fig. 5) gebildet. Die Antriebswelle 114 des Motors 113 ist über ein Exzentermechanismus 115 mit der Führungsstange 12 verbunden. Ferner trägt die Antriebswelle 114 des Motors 113 eine Schlitzscheibe 116 mit zwei (nicht dargestellten) Schlitzen, die von Lichtschranken 117, 118 abgetastet werden. Die beiden Schlitze definieren die Beladestellung (Fig. 8a) und die Entladestellung (Fig. 8b) des Shuttles 9. Die Transportstellung (Fig. 8c) ist weniger kritisch als die beiden vorhergenannten Stellungen. Sie wird lediglich bestimmt durch den Schrittmotor 113 zugeführte Schrittschalt-Impulse. Die Exzenter-Kupplung zwischen dem Motor 113 und der Führungsstange 12 ermöglicht eine ausreichende Kraftübersetzung in der Beladestellung des Shuttles 9 (Fig. 8a), in welcher das Shuttle 9 das Verschlußteil 98 entgegen der Kraft der Federn 99 verschieben muß.

Die Fig. 5 zeigt ferner die Antriebe für die Kippvorrichtung 65 und die Wendevorrichtung 93. Der Antrieb für die Kippvorrichtung wird von einem Schrittschaltmotor 119 gebildet. Die Antriebswelle 120 des Motors 119 ist auch hier wiederum über ein Exzenter-Gestänge 121 mit einer Verbindungswelle 122 verbunden, welche über eine lösbare Kupplung 123 mit der Drehachse 68 der Kippvorrichtung 65 (Fig. 7a und 7b) gekuppelt ist. Das Exzentergestänge 121 ist notwendig, damit die Kippvorrichtung in der in Fig. 7b gezeigten Kippstellung das Schließteil 62 entgegen der Kraft der Feder 64 nach unten drücken kann. Auf der Verbindungswelle 122 sitzt ferner eine Schlitzscheibe 123 mit zwei (nicht dargestellten) Schlitzen, die die beiden Stellungen der Kippvorrichtung 65 in den Fig. 7a und 7b definieren. Die Schlitze werden durch Lichtschranken 124 und 125 abgetastet.

Der Antrieb für die Wendevorrichtung 93 (Fig. 6 und 8a bis 8c) ist von einem Schrittschaltmotor 126 gebildet. Die Ausgangswelle 127 des Motors 126 ist eine Kupplung direkt mit einer Verbindungswelle 128 verbunden, welche ihrerseits über eine lösbare Kupplung 129 mit der Drehachse 94 der Wendevorrichtung gekuppelt ist. Auf der Verbindungswelle 128 sitzt wiederum eine Schlitzscheibe 130 mit zwei (nicht dargestellten) Schlitzen, die von zwei Lichtschranken 131, 132 abgetastet werden. Die Schlitze definieren die beiden in den Fig. 8a und 8b gezeigten Stellungen der Wendevorrichtung 93.

Die Fig. 5 zeigt die Prüfeinheit 6 noch von der Rückseite. Man erkennt die Enden der Prüfstüfte 90 in dem Prüfstifthalter 91, auf die der Stecker 7 (s. Fig. 1) für den Anschluß zum Auswerte-Computer aufgesteckt wird.

Wie bereits erwähnt, müssen bei verschiedenen zu prüfenden Bauelementen (IC's) sowohl das Eingangsmagazin 2, als auch das Ausgangsmagazin 13 als auch die gesamte Prüfeinheit 6 ausgewechselt werden. Daneben wurde bei der Konstruktion der Einrichtung darauf geachtet, daß die Führungskanäle für die Bauelemente für den Fall stets zugänglich sind, daß ein Bauelement stecken bleiben sollte. Dazu sind die Führungskanäle über den größten Teil ihrer Länge C-förmig gestaltet. In Fig. 6 kann dazu der die Zylinder 81 und 86 sowie den Prüfkäfig 78 enthaltende Block aus der Prüfeinheit herausgenommen werden, wenn der Hebel 133 nach unten geschwenkt und eine nur im Ansatz sichtbare um eine Achse 134 schwenkbare Klemmgabel 135 von dem erwähnten Block weggeklappt wird. Ferner sind die ebenfalls in Fig. 6 sichtbare Kippvorrichtung 65 und die Wendevorrichtung 93 so konstruiert, daß darin befindliche Bauelemente auch von einer Seite zugänglich sind. Dies gilt ebenso für die Vereinzelungsvorrichtung 44 und das Shuttle 9.

Sämtliche Teile, die Bauelemente führende Kanäle enthalten, werden vorzugsweise aus Metall hergestellt. Bei dem Prüfkäfig müssen jedoch die mit den Prüfstiften bzw. den Kontaktbahnen der Bauelemente in Berührung kommenden Teile aus Isoliermaterial, vorzugsweise aus Kunststoff bestehen, damit die Prüfstifte bzw. die Kontaktbahnen keine elektrische Verbindung haben. Das gleich gilt für den Prüfstifthalter.

In Zusammenhang mit Fig. 5 ist auch noch folgendes zu bemerken. Die Prüfeinheit 6 ist dort mit seitlichen Platten 150 zur Wärme- bzw. Kälteisolierung versehen. Wenn eine oder beide Platten 150 entfernt werden, so können weitere Prüfeinheiten 6 angesetzt werden, deren Kippvorrichtung und Wendevorrichtung ebenfalls von den Schrittmotoren 119 und 126 betätigt werden, indem die entsprechenden Achswellen einfach gekoppelt werden. Auf diese Weise können mehrere Prüfeinheiten 6 parallel betrieben werden. Die Zahl der parallel betreibbaren Prüfeinheiten 6 hängt von der Zeit ab, die der Auswerte-Computer benötigt. Diese ist umso länger, je mehr Anschlußkontakte die Bauelemente haben. Die Auswertezeit kann also so lang sein, daß mehrere Prüfeinheiten 6 von einem einzigen Eingangsmagazin 2 nacheinander mit Bauelementen geladen und von einem einzigen Shuttle nacheinander entladen werden.

Anstelle eines beweglichen Eingangsmagazins 2 kann auch ein ortsfestes Eingangsmagazin verwendet werden. In diesem Fall kann zwischen dem Eingangsmagazin und der Prüfeinheit ebenfalls ein Shuttle vorgesehen werden.

Ebenso ist es möglich anstelle des ortsfesten Ausgangsmagazins ein bewegliches Ausgangsmagazin zu verwenden und dann das bisher zwischen der Prüfeinheit und dem Ausgangsmagazin vorgesehene Shuttle einzusparen.

Die CC-Bauelemente (chip carrier) haben eine freie Rückenfläche. Das Durchlaufkonzept für diese IC-Bauelemente ist bei der zuvor beschriebenen Einrichtung so gewählt, daß die Bauelemente auf der freien Rückenfläche sowohl in das Eingangsmagazin als auch - nach der Prüfung - in das Ausgangsmagazin einlaufen. Allerdings sind die CC-Bauelemente beim Einlaufen in das Ausgangsmagazin um 180° gedreht worden, derart, daß diejenige Stirnfläche, die im Eingangsmagazin in Transportrichtung vorn ist, im Ausgangsmagazin nunmehr hinten liegt. Diese Drehung ist notwendig, weil die CC-Bauelemente in der Regel in Magazinstangen transportiert werden, in denen sie hintereinander in Reihe angeordnet sind. Die ungeprüften Bauelemente werden dadurch in einen Magazinkanal des Eingangsmagazins eingeführt, daß ein mit ihnen gefülltes Stangenmagazin mit seinem Füllende an den Eingang des Magazinkanals angesetzt wird, worauf die Bauelemente in den Magazinkanal rutschen. Die Füllung eines leeren Stangenmagazins mit geprüften Bauelementen erfolgt dadurch, daß das Füllende des leeren Stangenmagazins in den Ausgang des Ausgangsmagazins angesetzt wird, wobei die geprüften Bauelemente aus dem betreffenden Magazinkanal des Ausgangsmagazins in das Stangenmagazin hineinrutschen. Die Bauelemente müssen in dem Stangenmagazin eine bestimmte Ausrichtung haben, dergestalt, daß beispielsweise ein an einer Stirnseite des Bauelementes befindliche Anschlußkontakt (z.B. NULL-pin) zum Füllende des Stangenmagazins zeigt. Um dies zu gewährleisten, ist die 180°-Drehung der Bauelemente in der zuvor beschriebenen Weise erforderlich. Sie wird durch die dem Shuttle vorgeschaltete Wendevorrichtung erreicht.

**Patentansprüche**

1. Einrichtung zum Prüfen und Sortieren von elektronischen Bauelementen, insbesondere integrierten Chips, mit folgenden Merkmalen:

    a) ein ein Gefälle aufweisender Prüfkanal (69), in dem die Bauelemente (36) durch Schwerkraft transportiert werden,

    b) seitlich am Prüfkanal (69) ortsfest in einem Prüfkontakthalter (91; 140) angeordnete und von diesem vorstehende Prüfkontakte (90; 148),

c) ein quer zur Transportrichtung der Bauelemente (36) verschiebbarer Prüfkäfig (78; 142), der einen Prüfraum (88) zur Aufnahme eines zu prüfenden Bauelementes (36) aufweist, wobei der Prüfraum (88) einen Teil des Prüfkanals (69) bildet,

d) Öffnungen (89; 145) in dem Prüfkäfig (78;142), durch die bei Verschiebung des Prüfkäfig (78; 142) die ortsfesten Prüfkontakte (90; 148) in den Prüfraum (88) eintreten können.

2. Einrichtung nach Anspruch 1, **dadurch gekennzeichnet,** daß die Prüfkontakte von Prüfstiften (90) gebildet sind und daß die Öffnungen in dem Prüfkäfig (78) Löcher (89) sind.

3. Einrichtung nach Anspruch 2, **dadurch gekennzeichnet,** daß der dem Prüfkäfig (78) zugewandte Endbereich der Prüfstifte (90) gegenüber dem Hauptteil der Prüfstifte (90) teleskopisch verschiebbar ist, und daß an diesem Endbereich ein Stiftkopf, vorzugsweise in Form einer gezackten Krone vorgesehen ist.

4. Einrichtung nach Anspruch 1, **dadurch gekennzeichnet,** daß die Prüfkontakte von flachen Kontaktzungen (141) gebildet sind, daß die Öffnungen in dem Prüfkäfig (142) nach einer Seite hin offene Stützschlitze (145) für die Kontaktzungen (141) sind, in den die Kontaktzungen (141) an ihrer dem zu prüfenden Bauelement (36) abgewandten Kante abgestützt werden, und daß die Abmessungen so gewählt sind, daß die Anschlußkontakte (150) des im Prüfkäfig (142) befindlichen Bauelementes (36) beim Verschieben des Prüfkäfigs (142) mit der anderen Kante der Kontaktzungen (141) in Reibkontakt treten.

5. Einrichtung nach Anspruch 4, **dadurch gekennzeichnet,** daß die Kontaktzungen (141) in dem Bereich, in dem sie die Anschlußkontakte (150) der zu prüfenden Bauelemente (36) berühren sollen, einen verbreiterten Abschnitt (148) aufweisen, der am Ende spitz zuläuft.

6. Einrichtung nach Anspruch 4 oder 5, **dadurch gekennzeichnet,** daß sowohl der Prüfkontakthalter (140) als auch der Prüfkäfig (142) an jeweils zwei gegenüberliegenden Seiten mit die Stützschlitze (145) für die Kontaktzungen (141) enthaltenden Vorsprüngen (143 bis 147) versehen ist.

7. Einrichtung nach einem der vorstehenden Ansprüche, **dadurch gekennzeichnet,** daß an dem Prüfkontakthalter (91; 140) zwischen den Prüfkontakten (90; 141) ein Raum (92; 151) zur Unterbringung von Erdungskapazitäten vorgesehen ist.

8. Einrichtung nach einem der vorherstehenden Ansprüche, **dadurch gekennzeichnet,** daß ein Verschiebeantrieb (79; 80) für den Prüfkäfig (78; 142) vorgesehen ist.

## Claims

1. A device for testing and sorting electronic components, in particular integrated chips, having the following features:

a) a test channel (69) with a falling gradient, in which the components (36) are transported by gravity,

b) test contacts (90; 148) arranged laterally of the test channel (69) and held stationary in and projecting from a test contact holder (91; 140),

c) a test cage (78; 142) movable transverse to the direction of transport of the components (36) and having a test chamber (88) to receive a component (36) to be tested, said test chamber (88) forming a part of the test channel (69),

d) openings (89; 145) in the test cage (78; 142) through which the stationary test contacts (90; 148) can enter the test chamber (88) when the test cage (78; 142) is moved.

2. A device according to claim 1, characterised in that the test contacts comprise test pins (90) and that the openings in the test cage (78) are holes (89).

3. A device according to claim 2, characterised in that the part of the test pin (90) facing the test cage (78) is movable telescopically relative to the main part of the test pin (90) and that a head, preferably in the form of a serrated crown, is provided on this end part.

4. A device according to claim 1, characterised in that the test contacts comprise flat contact tongues (141), that the openings in the test cage (142) are supporting slits (145), open to one side, for the contact tongues (141), in which the contact tongues (141) are supported on their edges remote from the component (36) to be tested, and that the dimensions are chosen to be such that the electrical contacts (150) of the component (36) in the test cage (142) come into frictional contact with the other edges of the contact tongues (141) when the test cage (142) is moved.

5. A device according to claim 4, characterised in that in the region in which they touch the electrical contacts (150) of the component (36) to be tested the contact tongues (141) have a widened section that runs to a point at the end.

6. A device according to claim 4 or claim 5, characterised in that the test contact holder (140) and the test cage (142) are each provided on two opposite sides with projections (143; 144 and 146; 147) that include the slits (145) for supporting the contact tongues (141).

7. A device according to any one of the preceding claims, characterised in that a space (22; 159) to accommodate grounding capacitors is provided on the test contact holder (91; 140) between the test contacts (70; 141).

8. A device according to any one of the preceding claims, characterised in that a drive (79; 80) is provided for moving the test cage (78; 142).

**Revendications**

1. Installation pour le contrôle et le tri de composants électroniques, en particulier de puces intégrées, présentant les caractéristiques suivantes:
   a) une goulotte de contrôle (69) présentant une pente, à l'intérieur de laquelle les composants (36) sont transportés par gravité,
   b) sur le côté de la goulotte de contrôle (69), des contacts de contrôle (90; 148) montés fixes dans un porte-contacts de contrôle (91; 140) et faisant saillie par rapport à celui-ci,
   c) une cage de contrôle (78; 142) pouvant se déplacer en translation perpendiculairement à la direction de transport des composants (36), qui comporte une chambre de contrôle (88) recevant un composant (36) à contrôler, la chambre de contrôle (88) constituant une partie de la goulotte de contrôle (69),
   d) des ouvertures (89; 145) dans la cage de contrôle (78; 142), par lesquelles les contacts de contrôle (90; 148) fixes peuvent pénétrer dans la chambre de contrôle (88) lors du déplacement de la cage de contrôle (78; 142).

2. Installation selon la revendication 1 caractérisée en ce que les contacts de contrôle sont formés par des broches de contrôle (90) et en ce que les ouvertures dans la cage de contrôle (78) sont des trous (89).

3. Installation selon la revendication 2 caractérisée en ce que la partie terminale des broches de contrôle (90) tournée vers la cage de contrôle (78) peut être déplacée de manière télescopique par rapport au corps principal des broches de contact (90) et en ce qu'une tête de broche, de préférence en forme de couronne dentelée, est prévue sur cette partie terminale.

4. Installation selon la revendication 1 caractérisée en ce que les contacts de contrôle sont formés par des languettes de contact (141) plates, en ce que les ouvertures dans la cage de contrôle (142) sont des fentes (145) ouvertes d'un côté servant d'appui pour les languettes de contact (141), dans lesquelles les languettes de contact (141) prennent appui par leur bord opposé au composant (36) à contrôler, et en ce que les dimensions sont choisies de manière telle que les contacts de connexion (150) du composant (36) se trouvant dans la cage de contrôle (142) entrent en contact de frottement avec l'autre bord des languettes de contact (141) lors du déplacement de la cage de contrôle (142).

5. Installation selon la revendication 4 caractérisée en ce que les languettes de contact (141), dans la région dans laquelle elles doivent venir en contact avec les contacts de connexion (150) des composants (36) à contrôler, comportent une partie élargie (148) qui se termine en pointe.

6. Installation selon la revendication 4 ou 5 caractérisée en ce que le porte-contacts de contrôle (140) et la cage de contrôle (142) sont munis chacun sur deux côtés opposés de bossages (143 à 147) contenant les fentes (145) servant d'appui aux languettes de contact (141).

7. Installation selon l'une des revendications précédentes caractérisée en ce qu'une chambre (92; 151) est prévue sur le porte-contacts de contrôle (91; 140), entre les contacts de contrôle (90; 141), pour la mise en place de capacités de mise à la terre.

8. Installation selon l'une des revendications précédentes caractérisée en ce qu'une commande de déplacement (79; 80) est prévue pour la cage de contrôle (78; 142).

FIG. 1

# FIG. 2

# FIG. 3

FIG. 4

FIG. 5

# FIG. 6

## FIG. 7b

## FIG. 7a

FIG. 8a

FIG. 8c

FIG. 8b

FIG. 9a

FIG. 9b

## FIG. 10a

## FIG. 10b

# FIG. 11

# FIG. 12